# FASCICULE DE BREVET EUROPEEN

(11) **EP 1 654 431 B1**
(45) Date de publication et mention de la délivrance du brevet: **30.11.2016**
(21) Numéro de dépôt: 04767930.3
(22) Date de dépôt: 29.07.2004
(51) Int. Cl.: B32B 17/10, F24J 2/46

(54) **ELEMENT FEUILLETE EN FORME DE PLAQUE AVEC UNE FIXATION DE POSITION POUR UN ASSEMBLAGE COLLE**
PLATTENFÖRMIGES, LAMINIERTES ELEMENT MIT POSITIONSFIXIERSELEMENT FÜR EINE VERBUNDENE ANORDNUNG
PLATE-SHAPED LAMINATED ELEMENT WITH POSITION FIXING ELEMENT FOR A BONDED ASSEMBLY

(30) Priorité: 08.08.2003 DE 10336359
(43) Date de publication de la demande: 10.05.2006
(73) Titulaire: SAINT-GOBAIN GLASS FRANCE, 92400 Courbevoie (FR)
(72) Inventeur: ERBAN, Christof, 52134 Herzogenrath (DE)
(74) Mandataire: Saint-Gobain Recherche
(86) Numéro de dépôt international: PCT/FR2004/050369
(87) Numéro de publication internationale: WO 2005/017297

(56) Documents cités:
- EP-A- 0 314 120
- EP-A- 0 918 119
- WO-A-01/38680
- US-A- 5 533 314

## Description

L'invention se rapporte à un élément feuilleté en forme de plaque avec une fixation de position comportant au moins un premier et un deuxième substrats qui sont assemblés l'un à l'autre, au moins indirectement par collage de surface au moyen d'une couche adhésive, ainsi qu'avec au moins un élément de support associé au premier substrat pour fixer l'élément feuilleté sur une infrastructure et une fixation de position active du deuxième substrat, au moins en cas de défaillance du collage.

Des éléments feuilletés en forme de plaque, qui se composent d'au moins deux substrats et d'une couche adhésive assemblant celles-ci par collage de surface ou d'un cadre d'écartement collé aux deux substrats, peuvent de façon connue être fixés sans châssis à des structures, en fixant à l'infrastructure uniquement le substrat tourné vers le bâtiment. Des exemples de tels éléments et de leurs fixations se trouvent dans les documents EP 277 535 A2 et EP 595 062 A1. La Demanderesse vend et utilise des éléments de support de ce type (trou borgne en contre-dépouille, ancrage d'un élément de support en forme de boulon avec cheville en contre-dépouille) sous la dénomination SGG Point XS.

Pour des raisons de sécurité, la fixation purement adhésive du substrat placé à l'extérieur est cependant la plupart du temps complétée par des moyens mécaniques, qui forment au moins une fixation de position du substrat extérieur en cas de défaillance du collage. Selon le document DE 693 10 389 T2 (correspondant à EP 552 101 B1), un substrat proche du bâtiment d'un élément de façade en vitrage isolant est fixé à l'aide de supports ponctuels montés sur ce dernier, tandis que le substrat extérieur distant du bâtiment n'est maintenu que par le cadre d'écartement et le collage. Pour assurer la position du substrat extérieur, il est prévu ici des attaches métalliques, qui sont fixées aux supports ponctuels et qui s'accrochent par-dessous aux arêtes inférieures des deux substrats.

Le document EP 319 695 A1 divulgue une fixation de position pour des éléments de façade en vitrage isolant, qui sont collés globalement à l'infrastructure sous forme de vitrage dit "structural glazing" (vitrage structurel). Dans une variante, la fixation de position est formée par des broches, qui s'accrochent dans des trous borgnes en contre-dépouille du substrat extérieur distant du bâtiment des éléments de vitrage isolant, et qui sont retenus par l'infrastructure en cas de défaillance du collage.

Le document DE 197 51 124 C1 décrit un élément feuilleté avec des supports qui traversent un des substrats et qui sont fixés à l'aide d'une cheville en contre-dépouille dans un trou borgne en contre-dépouille du deuxième substrat. Une solution analogue est divulguée dans le document DE 100 54 816 A1, dans lequel un support de type broche est fixé à l'aide d'une masse de remplissage durcissable dans un trou borgne du deuxième substrat.

L'invention a pour objet de procurer un élément feuilleté en forme de plaque pour la construction avec une fixation de position simple.

Ce problème est résolu conformément à l'invention par les caractéristiques de la revendication 1.

Les caractéristiques des revendications dépendantes présentent des formes de réalisation avantageuses de cette invention.

La fixation mécanique sûre du premier substrat suffit en principe comme base pour une fixation de position relative indirecte du deuxième substrat. De préférence, la fixation de position relative des deux substrats est assurée par la pose d'au moins un élément de fixation traversant le plan d'assemblage entre les deux substrats et s'engageant dans les deux substrats. Elle agit de façon particulièrement discrète et indépendamment des supports de l'élément feuilleté.

Il va de soi que le nombre des éléments de fixation à installer par élément feuilleté dépend de la surface des éléments feuilletés, le cas échéant de la position de montage (verticale, inclinée, horizontale) et aussi du poids du substrat à fixer.

En principe, des éléments de vitrage isolant pourraient certes aussi être pourvus de telles fixations de position. Une utilisation préférée de ces fixations de position porte cependant sur des substrats feuilletées avec deux substrats et une couche adhésive assemblant ceux-ci l'un à l'autre par un collage de surface. La suite de la description se rapporte dès lors à ce type, sans pour autant vouloir en exclure d'autres.

Les éléments feuilletés peuvent être équipés d'autres éléments fonctionnels, en particulier électriques, par exemple des cellules solaires logées entre les substrats , des couches de chauffage, des éléments d'antenne ou d'alarme. Il va de soi que la fixation de position respectivement les éléments de fixation correspondants doivent toujours être installés de façon à ne gêner en aucune façon les éléments fonctionnels précités.

Si cela n'est pas absolument obligatoire mais néanmoins fortement recommandé, le support proprement dit des éléments feuilletés sur une infrastructure ne s'accroche qu'à un seul des substrats, notamment de manière avantageuse uniquement à la face du substrat située à l'opposé des éléments fonctionnels. Leur emplacement peut dès lors être choisi librement, en tenant compte des exigences imposées par les efforts statiques et dynamiques ainsi que par l'infrastructure. La face de l'élément feuilleté libre en position de montage reste ainsi intacte.

Des éléments feuilletés ou de vitrage isolant, qui sont à leur tour collés sur une infrastructure ("structural glazing"), peuvent cependant être pourvus également de la fixation de position conforme à l'invention.

De même des éléments étagés, dans lesquels un (plus grand) substrat est maintenu par son bord ponctuellement avec des attaches sur une infrastructure ou dans un cadre, tandis qu'un deuxième substrat (plus petit) est uniquement collé au premier substrat, peuvent recevoir une fixation de position du type décrit ici. Une autre possibilité d'application concerne des éléments attachés ponctuellement au bord, dans lesquels le substrat à fixer comporte, dans la région des supports, uniquement des évidements en face du substrat fixé de même grandeur.

Enfin, il est également possible de prévoir une telle fixation de position directement entre un moyen d'écartement collé aux deux substrats, que ce soit sous la forme d'un cadre périphérique ou seulement par segments, et un ou les deux substrats, qu'il assemble. Cette forme de réalisation peut être appliquée non seulement aux moyens d'écartement usuels en profilés solides (métal, plastique, céramique, verre) mais aussi aux moyens d'écartement également connus en soi produits in situ par exemple par extrusion ou par moulage par injection. On pourrait même imaginer de disposer la fixation de position à nouveau entre les deux substrats à fixer l'un par rapport à l'autre, en traversant le moyen d'écartement. Bien entendu, dans le cas d'un élément de vitrage isolant avec un espace intermédiaire entre les substrats fermés de façon étanche au gaz, il faut veiller à ce que la fixation de position ne compromette pas l'étanchéité de l'arrangement.

Il va de soi que l'utilisation de la fixation de position conforme à l'invention n'exclut pas que des éléments de support sur l'infrastructure soutiennent également le deuxième substrat en plus du premier substrat.

Comme matériaux pour les éléments feuilletés, on peut envisager également, à côté des matériaux transparents comme le verre - de préférence trempé ou partiellement trempé - et le plastique, d'autres matériaux comme des tôles métalliques, des plaques de pierre ou de marbre, etc. Naturellement, des paires quelconques de matériaux différents peuvent aussi former un élément feuilleté du type discuté ici.

Il n'est pas absolument nécessaire d'assembler fermement les éléments de fixation avec les deux substrats (ou éventuellement avec le moyen d'écartement et la ou les substrats), même si leur simple séparation du feuilleté doit être empêchée. Dans le cadre de la fixation de position, un certain mouvement initial est tout à fait admissible. Les éléments de fixation doivent uniquement empêcher de façon fiable la propagation de ce dernier au-delà de la mesure encore admissible. Le collage ne cèdera pas brusquement mais par un processus de fluage, conservant ainsi une certaine adhérence résiduelle. L'exigence minimale imposée aux éléments de fixation n'est dès lors pas non plus de garantir l'adhérence des deux substrats perpendiculairement à leur extension superficielle. Néanmoins, ils peuvent remplir également cette condition avec un formage et/ou une fixation appropriée sur ou dans les substrats.

Selon une première forme de réalisation, un élément de fixation est introduit dans un perçage traversant les deux substrats, et de préférence de telle façon qu'il se termine à fleur des faces extérieures des deux substrats. Les conditions modernes de fabrication permettent, même dans des substrats qui sont percés avant la fabrication de l'élément feuilleté (substrat feuilleté) et qui sont ensuite trempées thermiquement pour augmenter leur résistance mécanique, de réaliser des perçages isolés avec une précision de position suffisante de telle façon que ceux-ci soient alignés sur un même axe avec de faibles écarts dans le feuilleté des deux substrats. De ce fait, il est possible de monter des éléments de fixation en forme de broches du type considéré ici a posteriori à peu de frais dans l'élément feuilleté terminé.

Il va de soi que la couche adhésive entre les deux substrats doit également présenter un évidement pour le passage de l'élément de fixation. Celui-ci doit éventuellement être pratiqué déjà avant l'assemblage, ou ultérieurement par des moyens appropriés, lorsque l'élément de fixation n'est posé qu'après l'assemblage des substrats.

Si l'on utilise par exemple une feuille adhésive thermoplastique, un élément de fixation peut alors être chauffé au-delà de la température de fusion de la feuille adhésive avant de le mettre en place et enfoncé ensuite à travers la feuille adhésive. Avec cette méthode, il serait inutile de pratiquer séparément un trou dans la feuille adhésive et on obtiendrait une fixation axiale et radiale de l'élément de fixation à l'aide de la couche adhésive qui y adhère.

Si le collage des deux substrats est réalisé par coulée d'une résine de coulée durcissable (comme cela est répandu dans le cas des modules solaires), un élément de fixation peut déjà être introduit avant la coulée et ensuite être fixé en direction axiale et radiale avec la résine de coulée, si une adhérence suffisante est garantie entre l'élément de fixation et la résine de coulée.

Les éléments de fixation peuvent aussi être fixés d'une autre manière à au moins un des deux substrats, par exemple par emboîtement et/ou par collage séparé. Si l'on utilise des éléments de fixation en matière plastique ou en métal mou (par exemple l'aluminium pur), ceux-ci peuvent, par une déformation élastique ou plastique propre, compenser aussi bien un sous-dimensionnement du perçage dans les substrats qu'un léger décalage latéral des perçages individuels. Des éléments de fixation déformables élastiquement ou plastiquement sont par exemple des douilles de serrage (broches creuses fendues longitudinalement) ou des broches pourvues de nervures extérieures longitudinales ou transversales. Grâce à leur déformation élastique et/ou plastique, on obtient une fixation radiale et axiale par serrage des éléments de fixation respectifs dans les évidements prévus à cet effet.

Selon une autre forme de réalisation, un des substrats présente un perçage traversant et l'autre substrat un trou borgne en alignement avec celui-ci. L'élément de fixation est introduit avant ou après l'assemblage des deux substrats, de préférence à nouveau de telle façon qu'il ne soit pas en saillie sur l'embouchure du perçage traversant. Son montage et/ou sa fixation peuvent être effectués comme on l'a décrit plus haut.

Selon encore une autre forme de réalisation, un élément de fixation peut être, suivant l'invention, logé entièrement dans l'élément feuilleté, à la manière d'une clavette parallèle, qui est bien connue dans la construction des machines. Les faces extérieures de l'élément feuilleté peuvent dans ce cas rester intactes; de même, on peut se passer d'une fixation particulière de l'élément de fixation. Toutefois, il faut pratiquer dans les deux faces intérieures des deux substrats dans le feuilleté des évidements (rainures, trous borgnes, ...) avec une précision de position aussi grande que possible et l'élément de fixation doit être introduit déjà avant l'assemblage des plaques par collage. Il s'agit d'une solution du problème certes particulièrement esthétique vue de l'extérieur, parce qu'elle est à peine perceptible, toutefois sa réalisation est relativement coûteuse.

Cette réalisation pourrait être menée de telle façon que, après la formation des évidements dans les deux substrats à assembler, on dépose d'abord le premier substrat avec l'évidement vers le haut, on introduit l'élément de fixation dans l'évidement, on pose éventuellement ensuite un film adhésif et enfin on dépose le deuxième substrat de telle façon que l'élément de fixation soit introduit dans l'évidement de celle-ci. Ensuite, on peut fabriquer le feuilleté collé. Lors du collage avec une résine de coulée, on introduit un cadre d'écartement de façon connue entre les deux substrats, et l'espace intermédiaire ainsi formé est rempli de la résine de coulée.

Les éléments de fixation peuvent être eux-mêmes fabriqués en toute matière (suffisamment résistante) et sous toute forme quelconque, par exemple avec une section transversale cylindrique, elliptique, polygonale, être creux ou massifs, lisses ou nervurés, avec des degrés, etc. Naturellement, les dimensions des évidements dans les substrats et des éléments de fixation doivent être accordées les unes aux autres de telle façon que, en cas de fluage du substrat à fixer, une extraction de l'élément de fixation sous une charge de cisaillement soit pratiquement exclue. D'autre part, il ne s'exerce pas d'effort important sur l'élément de fixation individuel, de sorte qu'il ne doit pas être exagérément solide.

D'autres détails et avantages de l'objet de l'invention apparaîtront dans les dessins d'un exemple de réalisation et dans sa description détaillée qui suit.

Dans ces dessins, qui sont des représentations simplifiées sans échelle particulière,
- la Fig. 1: est une vue en coupe d'une première forme de réalisation d'un élément feuilleté conforme à l'invention, dans la région d'un support et d'une fixation de position; et
- la Fig. 2: montre une seconde forme de réalisation analogue à la Fig. 1, avec une variante de la fixation de position.

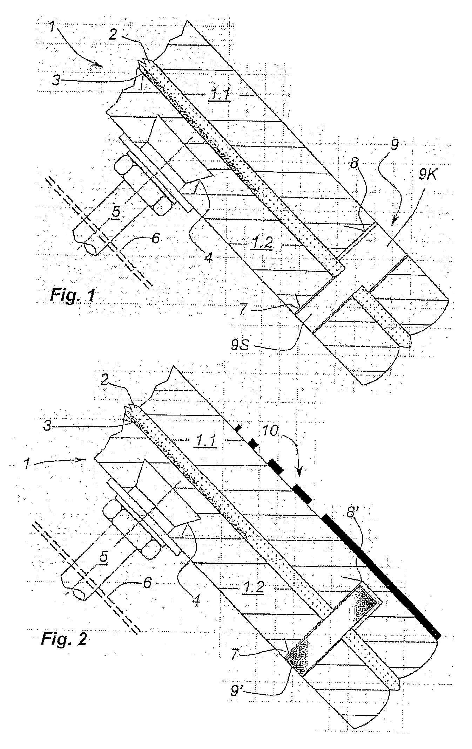

Selon la Fig. 1, un élément feuilleté 1 se compose d'un premier substrat 1.1 et d'une second substrat 1.2, ici tous les deux en verre. Une couche adhésive 2 assemble les deux substrats l'un à l'autre sur toute leur surface. Le substrat 1.2 placé en dessous dans le dessin porte sur sa face tournée vers la couche adhésive 2 un élément fonctionnel 3 indiqué uniquement de façon schématique sous la forme d'un revêtement. Dans un exemple de réalisation préféré de la présente invention, l'élément fonctionnel se compose d'un certain nombre de cellules solaires photovoltaïques, et l'élément feuilleté 1 forme ou comprend un module solaire.

La surface du substrat 1.2 située à l'extérieur/en dessous et à l'opposé de l'élément fonctionnel 3 est pourvue d'un trou borgne à contre-dépouille 4. Dans celui-ci est ancré, de façon connue à l'aide d'une cheville à contre-dépouille, un élément de support en forme de boulon 5 par exemple du type SGG Point XS, avec lequel l'élément feuilleté 1 peut être fixé à une infrastructure 6 représentée uniquement par une double ligne interrompue. Cette dernière peut être un mur de bâtiment, une charpente de support, un élément de pont et analogue.

L'élément de support 5 ne pénètre pas jusqu'au plan de la couche adhésive 2 et de l'élément fonctionnel 3. Il peut dès lors être positionné librement dans la zone de la surface de l'élément feuilleté 1, qui est recouverte par l'élément fonctionnel 3. Il va de soi qu'il sera prévu, selon la taille et le poids de l'élément feuilleté 1, plusieurs éléments de support 5 de ce type, qui forment ensemble le support mécanique de l'élément feuilleté 1 sur l'infrastructure 6.

On répète que cette fixation ponctuelle indiquée à titre d'exemple n'exclut pas la combinaison de la fixation de position avec d'autres possibilités de fixation d'éléments feuilletés de ce type et avec des éléments feuilletés comportant un moyen d'écartement.

Pour le cas d'application "module solaire", une position de montage de l'élément feuilleté 1 inclinée en oblique par rapport au rayonnement solaire est de règle, comme cela est indiqué ici, par exemple sur un toit de bâtiment et/ou sur une charpente de support. Par conséquent, la couche adhésive 2 et le substrat supérieur 1.1 à l'état monté sont en permanence soumises à une force de glissement vers le bas. Par nature, cette force est évacuée par les éléments de support 5. Des modules solaires peuvent cependant par leur nature être très chauds en service, de sorte qu'un fluage de la couche adhésive 2 ne peut pas être totalement exclu.

A proximité du bord extérieur droit, à l'extérieur de la zone de surface recouverte par l'élément fonctionnel 3, le substrat 1.2 est pourvu d'un perçage traversant 7. En alignement (sensiblement) axial avec celui-ci, un perçage traversant 8 est pratiqué dans le substrat 1.1. Le perçage 8 a un plus grand diamètre que le perçage 7. Un élément de fixation 9 avec une partie de tête plus épaisse 9K et une partie de tige 9S est introduit dans les deux perçages 7 et 8 de telle façon que le degré du passage de la partie de tête 9K à la partie de tige 9S s'applique sur la couche adhésive 2 (ou aussi soit noyé dans celle-ci). La partie de tige 9S traverse le plan de la couche adhésive 2 et s'engage dans le perçage 7 du substrat 1.2. La partie de tête 9K se trouve dans le perçage plus grand 8 du substrat 1.1.

La longueur de l'élément de fixation 9 correspond environ à l'épaisseur totale de l'élément feuilleté 1. Par conséquent, il se termine au moins approximativement à fleur des deux faces extérieures des substrats 1.1 et 1.2 et n'est pas en saillie au-dessus de celles-ci. Il est de préférence fixé dans les perçages 7 et 8 au moyen d'une colle, cette fixation ne constituant qu'une protection contre la chute.

Dans le cas d'une défaillance du collage, respectivement d'un fluage de la couche adhésive 2, le substrat supérieur 1.1 peut en tous cas se déplacer par rapport au substrat 1.2 jusqu'à ce que la paroi de son perçage 8 vienne toucher l'élément de fixation 9. De cette façon, il s'établit une fixation de position mécanique, par adaptation de forme, de l'assemblage collé maintenu par serrage ou selon le cas par la matière, qui satisfait aussi les exigences concernant la construction.

La Fig. 2 montre une variante de la fixation de position. Ici, seul le substrat 1.2 présente un perçage traversant 7, tandis qu'il est prévu un trou borgne 8' dans le substrat 1.1. Ce dernier se place à nouveau au moins approximativement en alignement axial avec le perçage traversant 7. Ici, les deux perçages ont sensiblement le même diamètre.

Un élément de fixation cylindrique 9 est à nouveau introduit comme fixation de position dans les deux perçages 7 et 8', de telle façon qu'il traverse le plan de la couche adhésive 2. Il est fixé dans les perçages à l'aide d'un collage résistant à la chaleur. La surface extérieure du substrat supérieur 1.1 reste intacte sans trou dans la région de la fixation de position. La longueur de l'élément de fixation 9 est accordée avec la profondeur des perçages 7 et 8', de telle façon que celui-ci puisse être monté en position entièrement enfoncée sans dépassement sur la face inférieure du substrat 1.2.

Pour le masquage purement visuel de la fixation de position, l'élément feuilleté 1 peut être pourvu, dans la zone du bord sur la surface du substrat 1.1, d'une couche colorée opaque 10, qui se termine en une trame ponctuelle vers le milieu du substrat. La couche colorée 10 peut par exemple être déposée par sérigraphie et cuite lors de la trempe du substrat 1.1. Bien entendu, dans le cas d'application "module solaire", elle doit être disposée à l'extérieur de la zone de la surface couverte par les cellules solaires.

Selon une variante à la Fig. 2, le trou borgne 8' pourrait être disposé dans le substrat inférieur 1.1 et le perçage traversant dans le substrat 1.2. La face d'extrémité de l'élément de fixation 9 tournée vers l'extérieur serait alors avantageusement colorée dans la même teinte que la couche colorée 10.

Selon une autre forme de réalisation non représentée de la Fig. 2, l'élément de fixation serait encore un peu plus court que ce qui est montré ici, et le perçage dans le substrat 1.1 serait également un trou borgne. L'élément de fixation 9 devrait alors être posé dans les évidements/trous borgnes alignés avant la fabrication du collage.

Il va de soi que, tout comme on l'a dit pour les éléments de support, il est prévu plusieurs éléments de fixation individuels illustrés dans les figures à titre d'exemple de réalisation, lorsque la taille et le poids des éléments feuilletés l'exigent. En règle générale, il suffira cependant de 2 éléments de fixation.

Une application de la fixation de position à un élément feuilleté pourvu d'un moyen d'écartement peut être accomplie de façon simple également à l'aide des Fig. 1 et 2. A la place du collage sur toute la surface avec la couche adhésive 2, il se forme ici un moyen d'écartement relativement étroit collé à celles-ci uniquement le long du bord des deux substrats. Celui-ci peut soit être entièrement traversé par un élément de fixation, tout comme la couche adhésive 2, de telle façon qu'il existe une fixation de position relative entre les deux substrats 1.1 et 1.2. On peut cependant aussi ne prévoir des éléments de fixation qu'entre le moyen d'écartement et une ou les deux substrats. Dans chacun de ces cas, les éléments de fixation traversent le joint collé entre le moyen d'écartement et le substrat concerné et soutiennent ce dernier en cas de défaillance éventuelle du collage.

## Revendications

1. Elément feuilleté en forme de plaque (1) comprenant :
- au moins un premier et un deuxième substrats (1.1, 1.2), qui sont assemblés l'un à l'autre, au moins indirectement, par collage de surface au moyen d'une couche adhésive (2),
- au moins un élément de support (5) associé au premier substrat (1.1) pour fixer l'élément feuilleté (1) sur une infrastructure (6), et
- une fixation de position active du deuxième substrat, au moins en cas de défaillance du collage,
**caractérisé en ce que** la fixation de position (7, 8, 9) n'est active qu'entre le premier et le deuxième substrats et est disposée à distance du bord de ceux-ci.

2. Elément feuilleté selon la revendication 1, **caractérisé en ce que** la fixation de position comprend au moins un élément de fixation (9) traversant un plan de l'assemblage collé entre les deux substrats (1.1, 1.2) et s'engageant chaque fois dans un évidement (7, 8) de chaque substrat.

3. Elément feuilleté selon la revendication 2, dans lequel l'évidement (7) dans au moins un des substrats est un perçage traversant.

4. Elément feuilleté selon la revendication 2 ou 3, dans lequel l'évidement (8) dans au moins un des substrats (1.1) ne débouche que dans une face de ce substrat tournée vers le collage (2), étant réalisé en particulier sous forme de trou borgne ou de rainure.

5. Elément feuilleté selon l'une quelconque des revendications 2 à 4, **caractérisé en ce que** l'élément de fixation (9) est réalisé sous la forme d'un tenon rond avec une partie de tête (9K) et une partie de tige (9S).

6. Elément feuilleté selon l'une quelconque des revendications 2 à 4, **caractérisé en ce que** l'élément de fixation (9') est réalisé sous la forme d'une broche cylindrique.

7. Elément feuilleté selon l'une quelconque des revendications précédentes, **caractérisé en ce que** la fixation de position n'est pas en saillie sur les surfaces des deux substrats (1.1, 1.2).

8. Elément feuilleté selon l'une quelconque des revendications précédentes, **caractérisé en ce qu'**il est prévu un masquage visuel (10) dans la région de la fixation de position.

9. Elément feuilleté selon l'une quelconque des revendications précédentes, **caractérisé en ce qu'**un élément de fixation de la fixation de position est fixé par collage dans un évidement, dans lequel il est introduit.

10. Elément feuilleté selon l'une quelconque des revendications précédentes, **caractérisé en ce qu'**un élément de fixation de la fixation de position est calé par adhérence dans un évidement, dans lequel il est introduit.

11. Elément feuilleté selon la revendication 10, **caractérisé en ce que** l'élément de fixation comprend au moins un élément déformable élastiquement et/ou plastiquement lors de son introduction dans l'évidement.

12. Elément feuilleté selon l'une quelconque des revendications précédentes, **caractérisé en ce qu'**un élément de fixation de la fixation de position est fixé par assemblage avec le collage des deux substrats dans un évidement dans lequel il est introduit.

13. Elément feuilleté selon l'une quelconque des revendications précédentes, **caractérisé en ce qu'**il comprend au moins un élément fonctionnel (3), en particulier des cellules solaires, disposé entre les deux substrats (1.1, 1.2).

14. Elément feuilleté selon l'une quelconque des revendications précédentes, **caractérisé en ce qu'**au moins l'élément de support (5) associé au premier substrat (1.1) comprend un boulon de support, qui est fixé par adhérence et/ou par emboîtement, en particulier à l'aide d'une cheville à contre-dépouille, dans un trou borgne du substrat (1.1) débouchant à l'opposé du collage.

15. Elément feuilleté selon l'une quelconque des revendications précédentes 1 à 13, **caractérisé en ce qu'**il est assemblé sur son bord à des éléments de support.

## Patentansprüche

1. Plattenförmiges Verbundelement (1), umfassend:
- mindestens ein erstes und ein zweites Substrat (1.1, 1.2), die, zumindest indirekt, durch Flächenverklebung mittels einer Klebeschicht (2) verbunden sind,
- mindestens ein Trägerelement (5), das dem ersten Substrat (1.1) zugeordnet ist, um das Verbundelement (1) auf einer Infrastruktur (6) zu fixieren, und
- eine aktive Positionsfixierung des zweiten Substrats, mindestens im Falle eines Versagens der Verklebung,
**dadurch gekennzeichnet, dass** die Positionsfixierung (7, 8, 9) nur zwischen dem ersten und dem zweiten Substrat aktiv ist und im Abstand zu deren Rand angeordnet ist.

2. Verbundelement nach Anspruch 1, **dadurch gekennzeichnet, dass** die Positionsfixierung mindestens ein Fixierungselement (9) umfasst, das eine Klebeverbindungsebene zwischen den zwei Substraten (1.1, 1.2) durchquert und jeweils mit einer Aussparung (7, 8) jedes Substrats in Eingriff kommt.

3. Verbundelement nach Anspruch 2, **dadurch gekennzeichnet, dass** die Aussparung (7) in mindestens einem der Substrate eine Durchgangsbohrung ist.

4. Verbundelement nach Anspruch 2 oder 3, **dadurch gekennzeichnet, dass** die Aussparung (8) in mindestens einem der Substrate (1.1) nur in einer Fläche dieses Substrats ausmündet, die der Verklebung (2) zugewandt ist, wobei sie insbesondere in Form eines Blindlochs oder einer Nut ausgebildet ist.

5. Verbundelement nach einem der Ansprüche 2 bis 4, **dadurch gekennzeichnet, dass** das Fixierungselement (9) in Form eines runden Zapfens mit einem Kopfteil (9K) und einem Schaftteil (9S) ausgebildet ist.

6. Verbundelement nach einem der Ansprüche 2 bis 4, **dadurch gekennzeichnet, dass** das Fixierungselement (9') in Form einer zylindrischen Spindel ausgebildet ist.

7. Verbundelement nach einem der vorhergehenden Ansprüche, **dadurch gekennzeichnet, dass** die Positionsfixierung nicht über die Oberflächen der zwei Substrate (1.1, 1.2) vorspringt.

8. Verbundelement nach einem der vorhergehenden Ansprüche, **dadurch gekennzeichnet, dass** eine visuelle Maskierung (10) in der Region der Positionsfixierung vorgesehen ist.

9. Verbundelement nach einem der vorhergehenden Ansprüche, **dadurch gekennzeichnet, dass** ein Fixierungselement der Positionsfixierung in einer Aussparung, in die es eingeführt ist, durch Verkleben fixiert ist.

10. Verbundelement nach einem der vorhergehenden Ansprüche, **dadurch gekennzeichnet, dass** ein Fixierungselement der Positionsfixierung in einer Aussparung, in die es eingeführt ist, kraftschlüssig festgelegt ist.

11. Verbundelement nach Anspruch 10, **dadurch gekennzeichnet, dass** das Fixierungselement mindestens ein Element umfasst, das bei seiner Einführung in die Aussparung elastisch und/oder plastisch verformbar ist.

12. Verbundelement nach einem der vorhergehenden Ansprüche, **dadurch gekennzeichnet, dass** ein Fixierungselement der Positionsfixierung in einer Aussparung, in die es eingeführt ist, durch Verbinden mit der Verklebung der zwei Substrate fixiert ist.

13. Verbundelement nach einem der vorhergehenden Ansprüche, **dadurch gekennzeichnet, dass** es ein Funktionselement (3), insbesondere Solarzellen, umfasst, das zwischen den zwei Substraten (1.1, 1.2) angeordnet ist.

14. Verbundelement nach einem der vorhergehenden Ansprüche, **dadurch gekennzeichnet, dass** mindestens das Trägerelement (5), das dem ersten Substrat (1.1) zugeordnet ist, einen Trägerbolzen umfasst, der kraftschlüssig und/oder formschlüssig, insbesondere mittels eines Hinterschnittdübels, in einem Blindloch des Substrats (1.1), das entgegengesetzt zu der Verklebung ausmündet, fixiert ist.

15. Verbundelement nach einem der vorhergehenden Ansprüche 1 bis 13, **dadurch gekennzeichnet, dass** es an seinem Rand mit Trägerelementen verbunden ist.

## Claims

1. A plate-shaped laminated element (1) comprising:
- at least a first and a second substrate (1.1, 1.2), which are joined together, at least indirectly, by surface bonding by means of a layer of adhesive (2),
- at least one support element (5) associated with the first substrate (1.1) in order to fasten the laminated element (1) to an infrastructure (6), and
- active position fastening of the second substrate, at least in the event of failure of the bonded joint, **characterized in that** the position fastening (7, 8, 9) is active only between the first and second substrates and is placed a certain distance from the edge of said substrates.

2. The laminated element as claimed in claim 1, **characterized in that** the position fastening comprises at least one fastening element (9) passing through a plane of the bonded assembly between the two substrates (1.1, 1.2) and each time engaging in a recess (7, 8) in each substrate.

3. The laminated element as claimed in claim 2, in which the recess (7) in at least one of the substrates is a through-drillhole.

4. The laminated element as claimed in claim 2 or 3, in which the drillhole (8) in at least one (1.1) of the substrates emerges only in that face of this substrate which is turned toward the adhesive (2), said recess being produced in particular in the form of a blind hole or of a groove.

5. The laminated element as claimed in any one of claims 2 to 4, **characterized in that** the fastening element (9) is produced in the form of a round tenon with a head part (9K) and a shank part (9S).

6. The laminated element as claimed in any one of claims 2 to 4, **characterized in that** the fastening element (9') is produced in the form of a cylindrical pin.

7. The laminated element as claimed in any one of the preceding claims, **characterized in that** the position fastening element does not project from the surfaces of the two substrates (1.1, 1.2).

8. The laminated element as claimed in any one of the preceding claims, **characterized in that** it is provided with visual masking (10) in the region of the position fastening.

9. The laminated element as claimed in any one of the preceding claims, **characterized in that** a fastening element for the position fastening is fastened by adhesive bonding in a recess into which said element is introduced.

10. The laminated element as claimed in any one of the preceding claims, **characterized in that** a fastening element for the position fastening is immobilized by adhesion in a recess into which it is introduced.

11. The laminated element as claimed in claim 10, **characterized in that** the fastening element comprises at least one element that can deform elastically and/or plastically upon its introduction into the recess.

12. The laminated element as claimed in any one of the preceding claims, **characterized in that** a fastening element for the position fastening is fastened by assembly of the two substrates with the adhesive in a recess into which it is introduced.

13. The laminated element as claimed in any one of the preceding claims, **characterized in that** it includes at least one functional element (3), in particular solar cells, said element being placed between the two substrates (1,1, 1.2).

14. The laminated element as claimed in any one of the preceding claims, **characterized in that** at least one support element (5) associated with the first substrate (1.1) comprises a support bolt, which is fastened by adhesion and/or by interlocking, in particular by means of an undercut dowel, in a blind hole in the substrate (1.1) emerging on the opposite side from the adhesive.

15. The laminated element as claimed in any one of the preceding claims 1 to 13, **characterized in that** it is joined along its edge to support elements.
